# EUROPEAN PATENT APPLICATION

(11) **EP 4 840 838 A1**
(43) Date of publication of application: **18.11.2026**
(21) Application number: 26178522.4
(22) Date of filing: 13.05.2026
(51) Int. Cl.: C04B 35/573, C04B 35/52, C04B 35/63, C04B 35/65, C04B 35/565, C04B 35/628, H10W 40/25

(54) **LOW PHONON SCATTERING STOCK/SUBSTRATE AND USES IN SEMICONDUCTOR HIGHPOWER DEVICE THERMAL MANAGEMENT**

(30) Priority: 14.05.2025 US 202563805757 P; 22.12.2025 US 202519430220; 07.05.2026 US 202619670269
(71) Applicant: II-VI Delaware, Inc., Wilmington, DE 19890 (US)
(72) Inventor: Murano, Robert, Wilmington, 19890 (US); Patkar, Shailesh, Wilmington, 19890 (US); Aghajanian, Michael, Wilmington, 19890 (US); Chen, Young-Kai, Wilmington, 19890 (US); Rummel, Steve, Wilmington, 19890 (US); Xu, Wen-Qing, Wilmington, 19890 (US); Wang, Jiwen, Wilmington, 19890 (US); Salamone, Samuel, Wilmington, 19890 (US)
(74) Representative: Bosch Jehle Patentanwaltsgesellschaft mbH

(57) **Abstract**

A low phonon scattering substrate includes a composite material comprising silicon carbide reaction bonds between thermal conductive particles. The composite material has a phonon scattering limit of less than about 40%. A semiconductor device using the low phonon scattering substrate as a signal distribution structure and a cooling system using the low phonon scattering substrate as a cool plate are also disclosed.

## Description

### CROSS-REFERENCE TO RELATED APPLICATIONS/INCORPORATION BY REFERENCE

The present application is a continuation-in-part of U.S. Application 19/430,220, filed December 22, 2025 and claims the benefit of and priority to U.S. Provisional Application 63/805,757, filed May 14, 2025, the disclosures of which are hereby incorporated herein by reference in their entirety.

### FIELD

Aspects of the present disclosure relate to reaction bonded composites and phonon scattering properties of such composites.

### BACKGROUND

Modern semiconductor devices due to device densities and/or operating frequencies may produce large amounts of heat. As such, thermal management and materials suitable for dissipation of such generated heat are needed to maintain peak operating efficiency of such devices.

Further limitations and disadvantages of conventional and traditional approaches will become apparent to one of skill in the art, through comparison of such approaches with some aspects of the present disclosure as set forth in the remainder of the present application with reference to the drawings.

### BRIEF SUMMARY

Reaction bonded composites having low phonon scattering properties are disclosed. Such low phonon scattering composites may be used to implement thermal management components for high-power semiconductor devices. Moreover, systems and methods of manufacturing such reaction bonded composites are disclosed. Such systems and/or methods may include reaction bonding diamond and/or other high thermal conductivity particle preforms as substantially shown in and/or described in connection with at least one of the figures, and as set forth more completely in the claims.

These and other advantages, aspects and novel features of the present disclosure, as well as details of an illustrated embodiment thereof, will be more fully understood from the following description and drawings.

### BRIEF DESCRIPTION OF SEVERAL VIEWS OF THE DRAWINGS

FIG. 1 is a schematic diagram of reaction bonded diamond/SiC/Si composites, in accordance with an example embodiment(s) of the disclosure.
FIG. 2 shows an example conventional reaction bonded diamond composite, in accordance with an example embodiment(s) of the disclosure.
FIGs 3A-B show modelling of thermal conductivity of reaction bonded diamond/SiC/Si composites, where FIG. 3A shows calculated thermal conductivity of diamond/SiC as a function of diamond content and FIG. 3B shows the effect of residual Si on thermal conductivity of diamond/SiC/Si (calculated), in accordance with an example embodiment(s) of the disclosure.

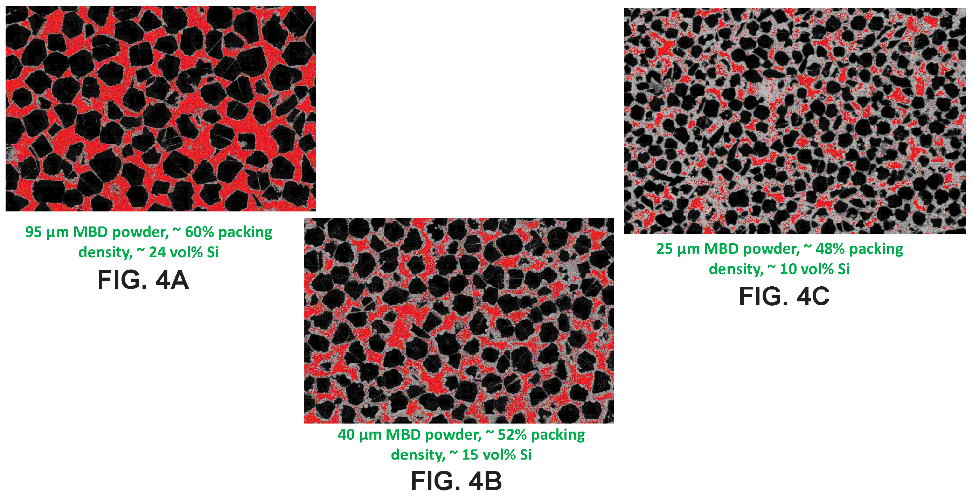

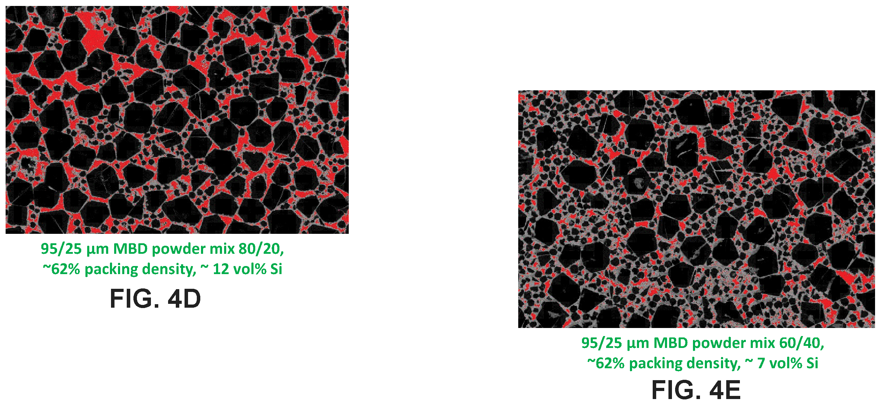

FIGs 4A-E shows results for various diamond particle sizes and ratios for MBD powders. FIG. 4A utilizes 95 µm MBD powder, having ~ 60% packing density, ~ 24 vol% residual Si; FIG. 4B utilizes 40 µm MBD powder, having ~ 52% packing density, ~ 15 vol% residual Si; FIG. 4C utilizes 25 µm MBD powder, having ~ 48% packing density, ~ 10 vol% residual Si; FIG. 4D utilizes 95/25 µm MBD powder mix 80/20, having ~62% packing density, ~ 12 vol% residual Si; FIG. 4E utilizes 95/25 µm MBD powder mix 60/40, having ~62% packing density, ~ 7 vol% residual Si; in accordance with an example embodiment(s) of the disclosure.
FIGs 5A-D shows results for various diamond particle sizes and ratios for RVD powders. FIG. 5A utilizes 65 µm RVD powder, having ~ 47% diamond, ~ 18 vol% residual Si; FIG. 5B utilizes 12 µm RVD powder, having ~ 38% diamond, ~ 1 vol% residual Si; FIG. 5C utilizes 65/12 µm RVD powder mix 80/20, having ~ 50% diamond, ~ 8 vol% residual Si; FIG. 5D utilizes 65/12 µm RVD powder mix 60/40, having ~ 58% diamond, ~ 0.3 vol% residual Si.; in accordance with an example embodiment(s) of the disclosure.
FIGs 6A-C show results based on packing methods. FIG. 6A utilizes 65/12 µm RVD powder mix 60/40, having ~ 58% diamond, ~ 0.5 vol% residual Si; FIG. 6B utilizes 65/12 µm RVD powder mix 60/40, having ~ 60% diamond, ~ 0.5 vol% residual Si; FIG. 6C utilizes 65/12 µm RVD powder mix 60/40, having ~ 62% diamond, ~ 0.05 vol% residual Si; in accordance with an example embodiment(s) of the disclosure.
FIGs 7A-E show results based on infiltration time. FIGs 7A and 7B show density and elastic modulus for samples having various infiltration times (15 min, 1 hr, 10 hr); FIGs 7C-7E show microstructures of these examples with various infiltration times; in accordance with an example embodiment(s) of the disclosure.
FIG. 8 depicts an example process of fabricating low phonon scattering boules and/or substrates.
FIG. 9 depicts an example packaged semiconductor chip or semiconductor device comprising a signal distribution structure with a low phonon scattering substrate, reaction bonded diamond/SiC composite substrate, and/or reaction bonded diamond/SiC/Si substrate.
FIG. 10 depicts an example cooling system comprising a cool plate with a low phonon scattering substrate, reaction bonded diamond/SiC composite substrate, and/or reaction bonded diamond/SiC/Si substrate.
FIG. 11 depicts example embodiments of low phonon scattering substrates, reaction bonded diamond/SiC composite substrates, and/or reaction bonded diamond/SiC/Si substrates suitable for the cooling system of FIG. 10.

### DETAILED DESCRIPTION

Aspects of the present disclosure are directed to reaction bonded composites and reaction bonded composites having a low phonon scattering properties suitable for thermal management of high-power semiconductor devices.

The figures illustrate a general manner of construction. Descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A may be directly contacting element B or indirectly connected to element B by an intervening element C. Similarly, the terms "over" or "on" may be used to describe two elements directly contacting each other or describe two elements indirectly connected by one or more other elements.

Also, any numerical range recited herein is intended to include all sub-ranges subsumed therein. For example, a range of "1 to 10" is intended to include any and all sub-ranges between and including the recited minimum value of 1 and the recited maximum value of 10, that is, all sub-ranges beginning with a minimum value equal to or greater than 1 and ending with a maximum value equal to or less than 10, and all sub-ranges in-between, e.g., 1 to 6.3, or 5.5 to 10, or 2.7 to 6.1.

Reaction bonded silicon carbide (RB-SiC) ceramic components are important in a variety of industries. Diamond may be used as the source of carbon, which produces materials having desirable properties. In one embodiment, diamond is in the form of particles. In other embodiments, the diamond may be in other forms, such as a coating on SiC particles.

Reaction bonded SiC (RB-SiC or SiSiC) has many positive attributes. Compared to conventionally processed SiC (sintered, hot pressed, chemical vapor deposition (CVD)), RB-SiC may be made in complex shapes (no shrinkage) and large sizes, may be tailored (properties, grain size, additional phases), may be produced in high purity, and may possess attractive process economics (e.g., relatively low process temperature and smaller equipment due to no process shrinkage). However, RB-SiC frequently contains a residual Si phase, owing to the infiltration process that is utilized. The presence of the Si phase limits use in various applications such as those at high temperature, and may negatively impact some properties such as thermal conductivity.

Traditional methods to form high diamond content composites also include sintering, hot pressing, and/or CVD. These methods are limited in many aspects, including diamond content, cost, size and shape capability, purity, grain size, properties, *etc.* Reaction bonded diamond-SiC composites *(e.g.* reaction bonded diamond or RB-diamond) have attractive size and shape capability, cost, purity, tailorability, *etc.* However, the presence of the residual Si phase reduces its thermal conductivity and limits uses in areas such as high temperature, corrosion, direct polishing, armor, wear, *etc.*

A "Si-free" version of reaction bonded composites (e.g. little to no residual Si phase) would have value in many markets where these is a need for attractive cost, significant size and shape capability and the attributes provided by a pure SiC microstructure.

Conventional RB-SiC (diamond) usually contains residual Si that reduces its thermal conductivity. As disclosed herein, composites are produced where the Si + diamond → SiC reaction occurs at a high volume yield, thus providing a low or ultra-low Si content composite where low Si content is less than about 2%, and ultra-low is less than about 0.5%. Methods to yield low or ultra-low Si include control of type of diamond particles *(e.g.,* RVD (crushed) vs. MBD (rounded) diamond powders); smaller particle sizes (i.e., more surface area for reaction); particle size blends (higher diamond particle packing, leaving less volume for Si/SiC matrix phase); and/or optimized process time to maximize Si + diamond → SiC reaction. Materials developed as discussed herein have low or ultra-low residual Si, with high (> 700 W/m-k). or ultra-high (> 800 W/m-k) thermal conductivity reached. In some embodiments, high thermal conductivity may be > 700 W/m-k, or from about 700-800 W/m-k or from about 700-750 W/m-k and ultra-high thermal conductivity may be > 800 W/m-k, or from about 800-900 W/m-k or 800-850 W/m-k.

In a disclosed example method, a preform containing diamond powder is fabricated. In some embodiments, the preform consists of only diamond powder of one or more particle sizes. The preform may be a loose mix of dry diamond powder(s), or a consolidated body formed by casting, pressing or other methods. Additionally, the reaction bonding may occur under vacuum (which would remove any oxygen or residual moisture such as from room humidity, *etc.).* In other embodiments, the reaction may be performed under inert atmosphere such as Ar or He.

Preforms may be made as green parts by a variety of methods such as with a dry powder alone (or a loose mix of dry powders), a pressed compact, or by making a slurry with water (or other solvents) which is shaped in a mold (or cast into a brick for later green machining). The slurry is frozen, dried or both in order to remove solvent and solidify the green part. Then a drying/carbonization procedure takes place; this may occur under an inert atmosphere (such as nitrogen). In some embodiments, the temperature range for this step may be from about 500°C to about 700°C. Carbon based, organic binders may also be used. During the carbonization procedure the organic binder is broken down and converted to carbon (pyrolyzed). In some embodiments, the organic binder content is about 1 to 10 wt.%. In other embodiments the organic binder content is about 1 to 8 wt.%, 1 to 6 wt.% or 1 to 4 wt.%.

This disclosure presents a method of producing a RB-SiC ceramic with low, ultra-low or nominally zero residual Si by utilizing diamond powder in the preform. Process steps include the following: (1) produce preform of ceramic and diamond particles (or 100% diamond particles), (2) preform may contain carbon in form other than diamond, such as pyrolyzed polymer or carbon particles, (3) reactively infiltrate preform with molten Si (aka reaction bond) at nominally 1410°C (melting point of Si) to 1600°C where Si + C → SiC reaction occurs (silicon reacts with carbon making silicon carbide), and (4) hold in furnace for more time than is needed for full infiltration to allow residual Si in microstructure to react with diamond to form SiC until nominally all elemental Si is removed from microstructure. Typical hold at temperature for standard reaction bonding is 0.5 to 2 hrs. When reacting Si with diamond, extra time is added *(i.e.,* infiltrate and then react). The total time at temperature with diamond may be 1-5 or 2-5 hrs. The preform is a sponge with interconnect channels for Si. Thus, with diamond, it is a 2-step process of (1) fill sponge (infiltrate) and (2) allow Si + diamond → SiC reaction to occur to remove elemental Si. In some embodiments, temperature may be increased during/after infiltration to allow the reaction to occur more rapidly.

In the present disclosure, methods are disclosed to create reaction bonded diamond-SiC composites with a low residual Si phase *(e.g.* nominally "Si-free") by utilization of diamond powder in the preform. Due to very high expansion as diamond reacts to form SiC, a low residual Si content component is produced. Standard reaction bonded SiC with no diamond in the preform may be made with a minimum residual Si content in the 8 to 10% range. However, for the present disclosure which utilizes diamond in the preform, the residual Si content may be 5% by volume of silicon or less; in some embodiments, the Si content is 3% by volume of silicon or less, 2% by volume of silicon or less, 1% by volume of silicon or less, 0.5% by volume of silicon or less or 0.1% by volume of silicon or less. In some embodiments, the residual Si content is 0.5% by volume or less. In other embodiments, the residual Si is about 1%-0% by volume; 0.5%-0% by volume; or 0.1%-0% by volume. In some embodiments, there may be no detectable Si remaining. Varying the diamond content of the preform, the diamond particle size, time and temperature of processing, and other variables may produce different results.

In one embodiment, the preform contains 100% diamond particles (preform contains only particles that are nominally 100% diamond). In another embodiment, diamond particles are utilized in a particle slurry containing the particles, a solvent and an optional dispersant/binder. In some embodiments, diamond powder(s) of specified size(s) are utilized in the preform. Possible diamond particles that may be utilized herein are disclosed below.

The diamond particles (powder) utilized may have a variety of particle sizes. In some embodiments, the particle size of the diamond particles is in the range of about 3 µm to about 95 µm. The diamond particles (powder) may be of two (or more) different particle sizes, where one is a coarse particle, and one is a fine particle. In some embodiments, larger (coarse) particles having a particle size of about 95-60 µm are utilized. In other embodiments, smaller particles (fine) particle size of about 12-30 µm are utilized. In other embodiments, very small diamond particles (ultra-fine, about 3 to 10 µm) are used to enhance the reaction of silicon and diamond to form SiC (small, high surface area particles react more robustly). Diamond particles of two or more sizes may be utilized so as to maximize packing efficiency. The small particles fit between the big particles in the particle array to enhance total packing in the preform. In some embodiments, diamond particles of two different sizes are utilized; in other embodiments, diamond particles of three different sizes are utilized; diamond particles of four different sizes are utilized; or diamond particles of five or more different sizes are utilized.

In one embodiment, a method of making a reaction bonded diamond-SiC composite with low residual Si is disclosed, the method comprising: producing a preform that comprises diamond particles, where the diamond particles are of two different sizes, infiltrating the preform with molten Si to produce an infiltrated preform; and reacting the molten Si and the diamond particles in the infiltrated preform, thus forming a reaction bonded diamond-SiC composite.

In some embodiments, the ratio of larger (coarse) to smaller (fine/ultra-fine) particles fall into particular ranges. In one embodiment, diamond particles of two different sizes are utilized that have a ratio of larger to smaller particles in the range of about 80-60 : 20-40.In some embodiments, the blend of coarse: fine diamond particles are between about 80:20 and 60:40. In other embodiments, the blend may be about 75:25; 70:30 or 65:35. Particle size measurement may include measurements of particle diameter, measurements of particle sizes and/or size distribution.

Particle size measurements may be made by ASTM D4464 which is a method of measuring particle size distribution by laser light scattering, or by other methods such as laser diffraction. Particle sizes may be described using values such as D10, D50 and D90. These are particle size values that may be determined from the particle size volume distribution curves and indicate the size below which 10%, 50% or 90% of all particles may be found, respectively. The D50 in particle size distribution is the median particle diameter, meaning it is the size where 50% of the particles (by volume or weight) are smaller and 50% are larger. It serves as a key indicator of the average particle size for a powder or material. Particle sizes described herein are D50 values.

The amount of diamond that reacts to SiC during the process is a function of the diamond particle size and packing in the preform. See Figure 4. For example, a preform that contains about 70 vol. percent diamond particles may react during the process described herein, leaving about 65 vol. percent of diamond and about < 2% residual Si (vol. percent) remaining in the composite material. In other embodiments, higher surface area of diamond in the preform *(i.e.,* by higher packing and/or finer particles) may be used and/or the reaction carried out longer, thus potentially leaving < 1% residual Si remaining; < 0.5% residual Si remaining; or <0.1% residual Si remaining by volume. If allowed by holding at temperature long enough, the diamond may react until all Si is exhausted (no residual Si remaining).

In the disclosed materials, a low final vol. percent of Si amount (low residual Si phase) in the "Si-free" material correlates with 10% by volume or below of Si remaining, with a lower limit of 0% Si (none detectable). In some embodiments, 9% by volume or below of Si is remaining; 8% by volume or below of Si is remaining; 7% by volume or below of Si is remaining; 6% by volume or below of Si is remaining; 5% by volume or below of Si is remaining; 4% by volume or below of Si is remaining; 3% by volume or below of Si is remaining; 2% by volume or below of Si is remaining; 1% by volume or below of Si is remaining; 0.5% by volume or below of Si is remaining; or 0.1% by volume or below of Si is remaining. In some embodiments, there is no detectable Si present (0% remaining).

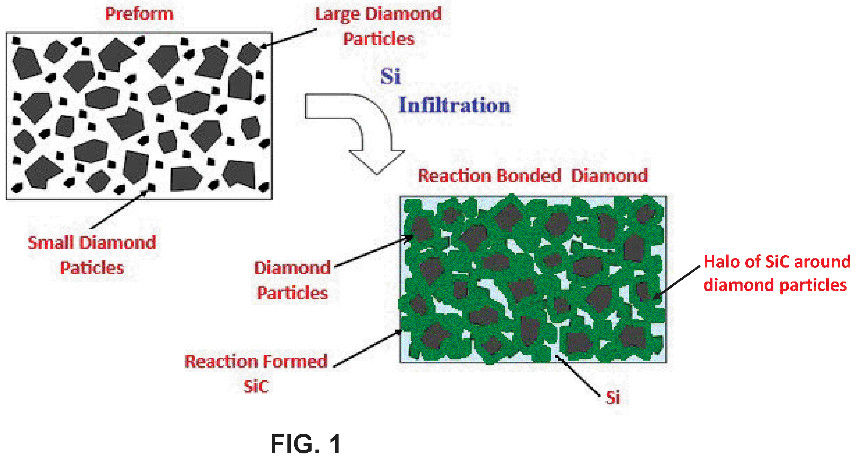

FIG. 1 is a diagram of conventional reaction bonded diamond composites produced by the reactive infiltration of molten Si into preforms of diamond particles. Upon infiltration, the molten Si reacts with the diamond to form SiC (Si + C → SiC), bonding the structure together. A typical final composite may consist of (1) the remaining original diamond, (2) reaction formed SiC and (3) residual Si. One issue that limits the thermal conductivity of this material is the presence of a residual Si phase, which has been shown both by modeling and by experimentation. The residual Si phase is an artifact of the reaction bonding process, which is also called the Si infiltration process. Note that a halo of SiC forms around each diamond particle during the reaction. The halo may partially or completely encapsulate the diamond particle. The halo consumes volume and thereby reduces space for the elemental Si phase.

In the creation of reaction bonded silicon carbide (RB-SiC) ceramic materials, preforms are often utilized. Many different preform processes exist (casting, molding, pressing, *etc.).* In some embodiments, methods as described herein may utilize diamond powder(s) of specified size in the preform.

Carbon may exist in several forms, such as carbon black, graphite, pyrolytic carbon, and diamond. Diamond is a high density form of carbon and given a specific volume contains more moles of carbon with respect to other forms of carbon. Since diamond is high molecular weight "carbon", the Si + diamond → SiC reaction is highly expansive (*i.e.,* reaction formed SiC may fill voids in preform). Also since diamond is high molecular weight carbon, the Si + diamond → SiC reaction is slow, thus allowing infiltration of the preform to occur, following which, reaction occurs. If the starting diamond powder in the preform has a small particle size, it may be fully reacted to SiC during the process, thus creating "Si-free" reaction bonded SiC.

Diamond materials that may be utilized include, but are not limited to, RVD (Resin-Vitrified Diamond) powder and/or MBD (Metal-Bonded Diamond) powder. RVD powder has crushed, irregular, and angular diamond particles, while MBD powder has blocky, and more rounded particles. MBD has a more consistent crystalline shape and has higher mechanical strength, wear resistance, and toughness. RVD powder has an irregular and angular shape, and is more fragile/brittle. Because of its irregular shape, RVD powder has higher surface area and is thus more reactive with molten Si. In other embodiments, diamond may be added to the preform in other forms, such as diamond coatings on SiC particles. In such an embodiment, the preform is produced including diamond coated SiC particles which is then infiltrated with molten Si to produce an infiltrated preform and the molten Si is then reacted with the diamond coating.

When the diamond is added to the preform in the form of diamond coated SiC particles, the SiC particles may have a particle size of about 10 to 100 microns and may have a diamond coating of about 10 to 50 microns in thickness. The use of diamond coated ceramic particles provides a cost advantage over the use of 100% diamond particles and puts the high molecular weight carbon material on the particle surfaces where it is desired for the Si + diamond → SiC reaction aimed at greatly reducing the residual Si content.

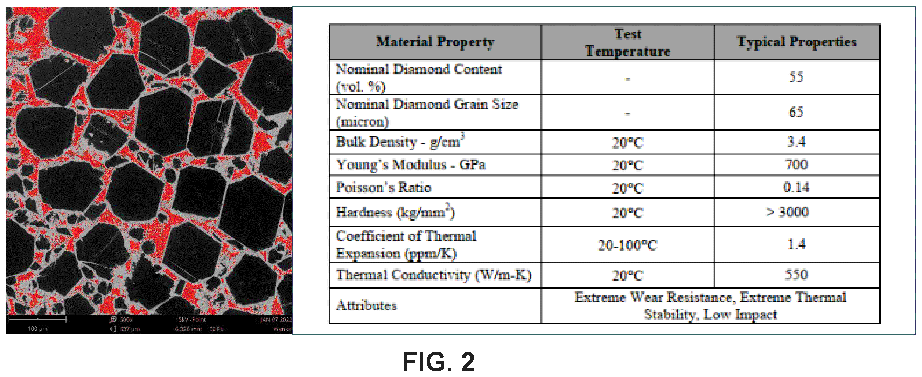

FIG. 2 shows an example conventional reaction bonded diamond composite. In Figure 2, on the left the microstructure shows diamond (black); SiC (grey); and residual Si (red). This material has a preform composition having two sizes of diamond particles: about 60% 65 µm diamond and about 20% 22 µm diamond; and also contains 20% 12 µm SiC in the preform, and results in a composite with a final diamond content of 55 vol. %. The residual Si content of this material is about 8 vol. %. Typical properties of such a material are shown on the right of Figure 2. Due to the presence of residual Si, the thermal conductivity of this version of material is relatively low at 550 W/ W/m-k.

As shown above, conventional RB-SiC (diamond) usually contains residual Si that reduces its thermal conductivity. As disclosed herein, composites are created that allow the reaction of silicon and carbon (diamond) to form SiC (Si + diamond → SiC) to occur at a high yield, thus providing an ultra-low Si content composite. Methods to yield low and ultra-low residual Si include control of type of diamond particles (RVD (crushed) vs. MBD (rounded) diamond powders); smaller particle sizes *(i.e.,* more surface area for reaction); particle size blends (higher diamond packing, leaving less volume for Si/SiC matrix phase); and/or optimized process time to maximize Si + diamond → SiC reaction. Materials discussed herein have near zero residual Si, with high (> 700 W/m-k) or ultra-high (> 800 W/m-k) thermal conductivity reached.

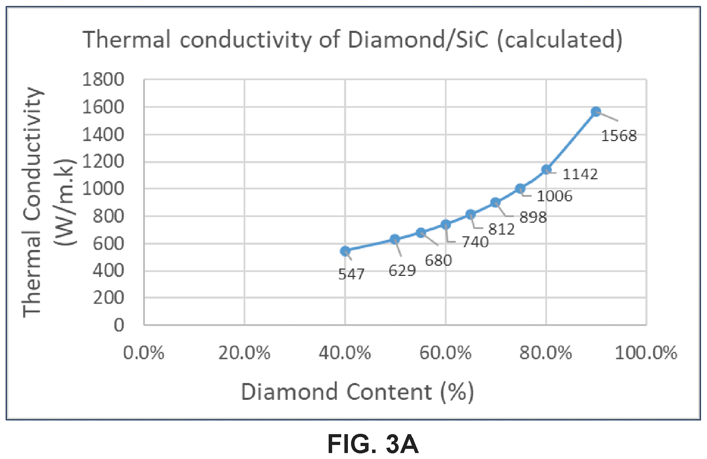

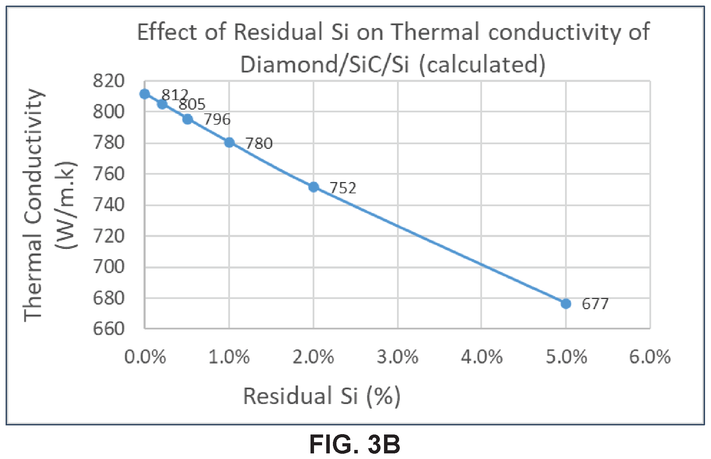

FIGs 3A-B show modelling of thermal conductivity of reaction bonded diamond/SiC/Si composites, where FIG. 3A shows calculated thermal conductivity of diamond/SiC as a function of diamond content and FIG. 3B shows the effect of residual Si on thermal conductivity of diamond/SiC/Si (calculated), in accordance with an example embodiment of the disclosure. Figure 3A shows modeling results for 65 vol% diamond content indicating that < 0.5 vol% residual Si is needed to achieve ultra-high thermal conductivity > 800 W/m-k. Figure 3B shows that the presence of residual Si may significantly reduce the thermal conductivity of the materials. For example, when the material has 65 vol% diamond with 5 vol% residual Si, the thermal conductivity is reduced from a theoretical 812 W/m-k to 677 W/m-k. (~17 % down).

Thus, to achieve ultra-high thermal conductivity, it is critical to increase the packing density of the diamond preform and to reduce the residual Si content to a very low level (< about 0.5%). The present disclosure illustrates that ultra-low residual Si (< about 0.5%) may be achieved by utilizing methods controlling one or more of diamond particle size and ratio; packing; and/or infiltration parameters.

Packing density may be measured by the green density of the preform. One method for this measurement is to produce a cylindrical or rectangular preform, measure mass, measure volume (from dimensions) and calculate density (i.e., the weigh and measure method). Other methods include Archimedes' principle with sealed surfaces (per ASTM B328) or Helium Pycnometry.

The amount of diamond is measured by analyzing the microstructure (image analysis using the open-source image processing program ImageJ) after infiltration. There is less diamond after infiltration than in the preform because of the halo of SiC on each diamond particle (see Figure 1). In some embodiments, preform packing may be up to 70%, resulting in a final diamond content of 65%.

FIGs 4A-E show microstructures of reaction bonded diamond composites using MBD powder made in accordance with this disclosure. The microstructures show diamond (black); SiC (grey); and residual Si (red). Figure 4A utilizes 95 µm MBD powder, having ~ 60% packing density, and results in ~ 24 vol% residual Si. Figure 4B utilizes 40 µm MBD powder, having ~ 52% packing density, and results in ~ 15 vol% residual Si. Figure 4C utilizes 25 µm MBD powder, having ~ 48% packing density, and results in ~ 10 vol% residual Si. For 4A-4C: Finer diamond powders with higher surface area provide greater Si + C → SiC reaction and thus less residual Si. Figure 4D utilizes 95/25 µm MBD powder mixed with a ratio of 80% 95 micron and 20% 25 micron diamond particles having ~62% packing density, and results in ~ 12 vol% residual Si. Figure 4E utilizes 95/25 µm MBD powder mixed with a ratio of 60% 95 micron and 40% 25 micron diamond particles, having ~62% packing density, and results in ~ 7 vol% residual Si. For FIGS. 4D-4E: diamond particle size blends provide higher packing (higher diamond content) and less residual Si. More fines in the blend are beneficial for reducing Si content (more surface area for reaction).

Finer diamond powders have more surface area for Si + C → SiC reaction to reduce residual Si content. Also, particle size blends pack better to provide higher final diamond content.

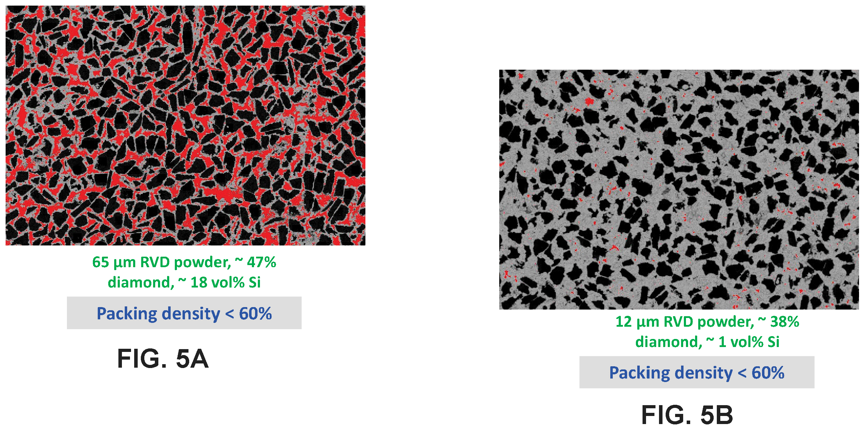

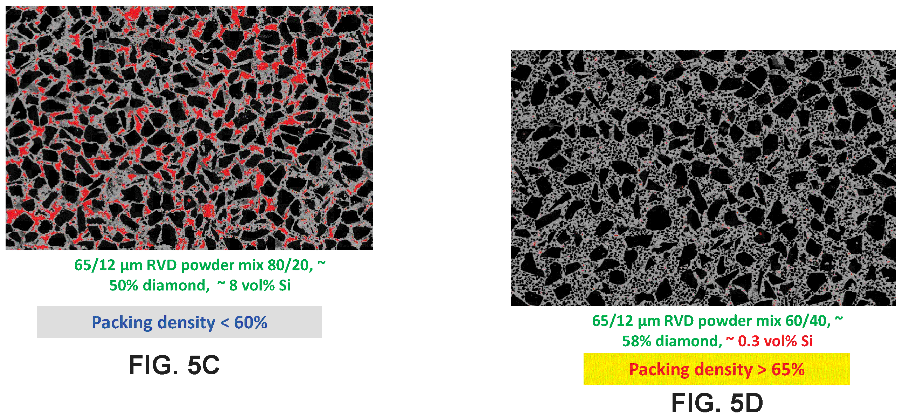

FIGs 5A-D show microstructures of reaction bonded diamond composites using RVD powder made in accordance with this disclosure. The microstructures show diamond (black); reaction formed SiC (grey); and residual Si (red). Figure 5A utilizes 65 µm RVD powder, and results in a composite having ~ 47% diamond, ~ 18 vol% residual Si (packing density < 60%). Figure 5B utilizes 12 µm RVD powder, and results in a composite having ~ 38% diamond, ~ 1 vol% residual Si (packing density < 60%). Figure 5C utilizes 65/12 µm RVD powder mix 80/20, and results in a composite having ~ 50% diamond, ~ 8 vol% residual Si (packing density < 60%). Figure 5D utilizes 65/12 µm RVD powder mix 60/40, and results in a composite having ~ 58% diamond, ~ 0.3 vol% residual Si (packing density > 65%). Increasing the packing density allows for reduction of the residual Si (see below). Also, in the microstructures, the amount of diamond after infiltration is measured. There is less diamond after infiltration than in the preform because of the halo of SiC that is grown on each diamond particle (see Figure 1).

Figures 5A-C have a packing density <60%. Figure 5D has a packing density > 65%. The RVD (crushed crystal) diamond powders have higher surface area than those of MBD diamond powders with similar sizes due to RVD's more irregular shape. The mixtures with high content of small RVD particles (*e.g*., 40% 12µm) are able to reach high packing density (>65 %) and low residual Si (< 0.5%). As discussed above, packing density may be measured in the preform by green density, and for an infiltrated part, packing density may be measured by image analysis of the microstructure. In some embodiments, packing density is >65 %, >70 %, or from about 60-80% (see also below).

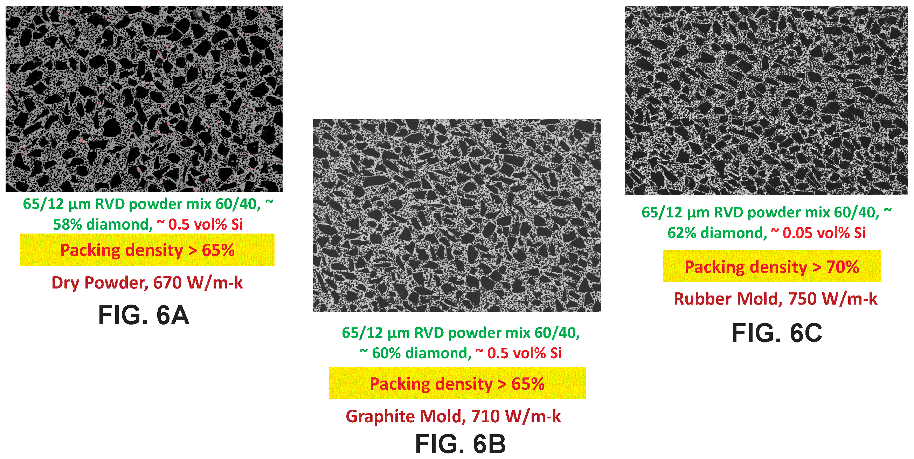

FIGs 6A-C show microstructural images of final infiltrated materials, using different powder packing methods. Figure 6A utilizes 65/12 µm RVD powder mixed in a 60% 65 micron and 40% 12 micron ratio, and results in a composite having ~ 58% diamond, ~ 0.5 vol% residual Si. This material has a packing density > 65%. The preform was dry powder in a graphite mold, and the thermal conductivity is 670 W/m-k. Figure 6B utilizes 65/12 µm RVD powder mixed in a 60%/40% ratio, and results in a composite having ~ 60% diamond, ~ 0.5 vol% residual Si. This material has a packing density > 65%. The preform was created from a powder slurry in a graphite mold, and the thermal conductivity is 710 W/m-k. Figure 6C utilizes 65/12 µm RVD powder mixed in a 60%/40% ratio, and results in a composite having ~ 62% diamond, ~ 0.05 vol% residual Si. This material has a packing density > 70%. The preform was created from a powder slurry in a rubber mold that allows higher particle packing than in graphite mold (due to reduced interaction between the mold wall and the preform), and the thermal conductivity is 750 W/m-k.

As discussed above, FIG. 6A is a material made from dry powder in a graphite mold, FIG. 6B is a material made from a powder slurry in a graphite mold and FIG. 6C is a material made from a powder slurry in a rubber mold. Powder slurries are made with a solvent such as water. Dispersants/binders may also be used in the slurry, including, but not limited to, Tamol^{®} which is a condensation product of naphtalenesulphonic acid. In the examples above, utilizing a powder slurry to create the preform gives higher thermal conductivity, and further utilizing a rubber mold for creation of the preform gives the highest packing density of the preform, which leads to highest thermal conductivity of the infiltrated materials.

Thus, as disclosed herein, by development of the packing method (such as utilizing a slurry and rubber mold casting), the thermal conductivity of the diamond/SiC composite may reach 750 W/m-k and above. Particle packing in a preform may be increased via the use of particle shape (rounder is better), particle size distribution (blend of sizes is better) and optimized preform processing (one example is casting in a rubber vs. graphite mold that impacts less interaction, such as mold wall friction, with the particles).

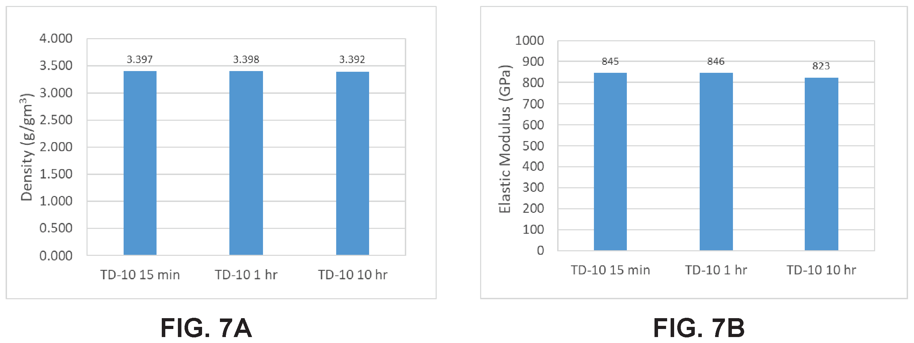

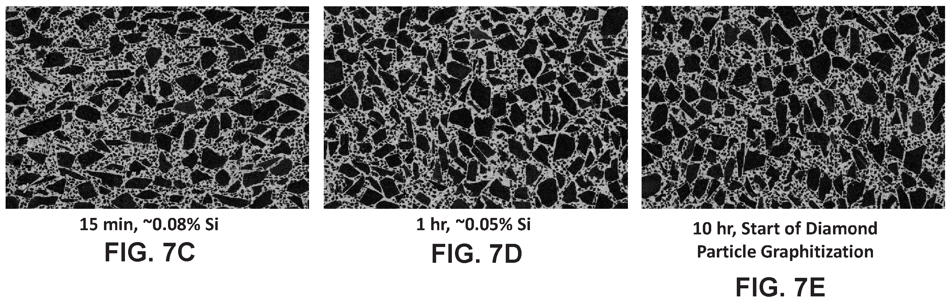

FIGs 7A-E show results based on infiltration time at 1500°C in a vacuum atmosphere utilizing 65/12 µm RVD powder mixed in a 60%/40% ratio made from a powder slurry. FIGs 7A and 7B show density and elastic modulus for samples having various infiltration times (15 min, 1 hr, 10 hr). FIGs 7C-7E show microstructures of these examples with various infiltration times. FIG. 7C shows 15 min infiltration time, ~0.08% residual Si. FIG. 7D shows 1 hr infiltration time, ~0.05% residual Si. FIG. 7E shows 10 hr infiltration time, and the start of diamond particle graphitization. At first, increasing infiltration time reduces residual Si content via the Si + diamond → SiC reaction, which leads to higher thermal conductivity. However, too much time at ~1500°C may begin to degrade the diamond via conversion to graphite, which may have an adverse effect on thermal conductivity. Thus, in some embodiments, infiltration time may be about an hour, or from 1-10 hrs; 1-8 hrs; 1-6 hrs, 1-4 hrs or 1-2 hrs.

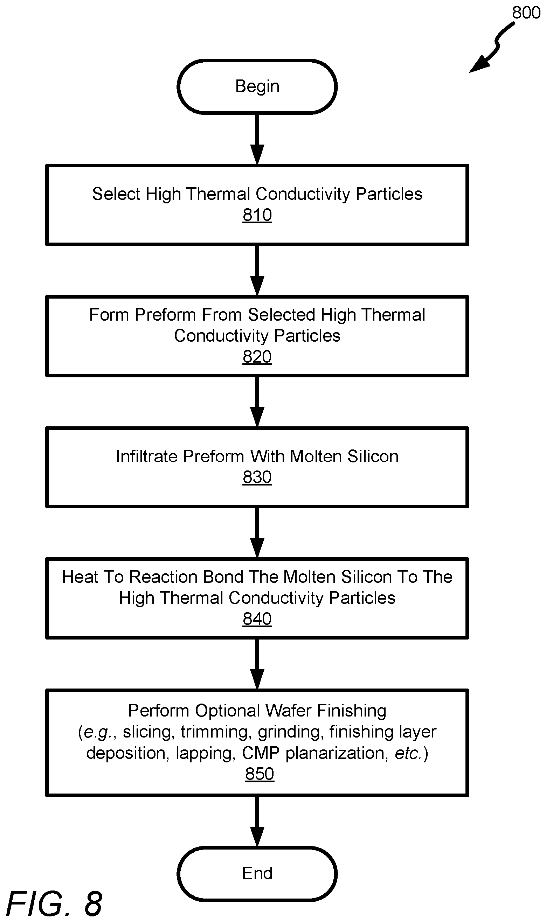

Referring now to FIG. 8, an example process 800 of manufacturing a low phonon scattering substrate is shown. In general, the example process 800 may be implemented in a manner similar to the above-described methods for forming Si-free diamond-SiC composites. In particular, suitable high thermal conductivity ceramic powders may be selected at 810, formed into a preform at 820, and infiltrated with silicon at 830 as set forth above. In particular, at 810, the process 800 may include selecting various high thermal conductivity ceramic powders such as silicon carbide particles, diamond particles, silicon carbide coated diamond particles, boron nitride particles, and/or other high thermal conductive ceramic powders. Moreover, the selected high thermal conductivity ceramic may possess any of the properties of the above-noted particles. In particular, a blend of fine and coarse particles may be selected so as to obtain tightly packed preforms.

At 820, the process 800 may include forming a preform from the selected high thermal conductivity ceramic powders. In particular, the process 800 may form preforms using any of the above-noted preform techniques including the formation of dry powder preforms and green part preforms. In embodiments utilizing boron nitride particles, the process 800 may form green part preforms with a subsequent carbonization of binder materials in the green part preform. Such carbonization may coat the boron nitride with carbon to improve its wettability and subsequent infiltration with molten silicon.

Similar to the above processes, the Si infiltrated preform may be heated at 840 so as to react the high thermal conductivity ceramic powders with the molten Si and form a reaction bonded composite. In a manner similar to the above-disclosed methods, the Si infiltrated preform may be heated for a sufficient length of time so as to completely react or mostly react the molten Si with the high thermal conductivity ceramic powders and produce a low phonon scattering (LPS) substrate or boule.

At 850, the LPS substrate or boule may be further processed. In particular, the LPS substrate or boule may be sliced to provide one or more LPS wafers and the one or more LPS wafers may be further prepared for semiconductor standards. For example, the thickness and/or edge of each LPS wafer may be processed. In particular, upper and/or lower major surfaces of each LPS wafer may be ground to reduce the thickness of each LPS wafer to a desired thickness. Further, lateral surfaces and/or edges of each LPS wafer may be trimmed and/or ground to provide notched or flat preparations.

Surfaces of the upper and/or lower surfaces of the LPS wafers may undergo a finishing process. For example, such surfaces may be finished through deposition of a layer of material such as SiC, Si, *etc.* Such finishing layers may be a few microns to a *few* hundred microns thick. Moreover, such finishing layers may be applied to only one of the upper and/or lower major surfaces or may be applied to both the upper and the lower major surfaces. Moreover, such finishing layers may create interfaces that provide a reduce thermal boundary resistance (TBR).

Furthermore, the upper, lower, and/or lateral surfaces of the LPS wafers may undergo lapping and/or planarization so as to prepare the LPS wafers for semiconductor and/or optical applications. For example, such preparation may include chemical mechanical planarization (CMP); plasma treatment, such as water vapor plasma treatment; CMP with selective CMP slurries; selective additive: amino acid or protein related derivatives; nucleosides or DNA/RNA base derivatives; and/or laser and/or ion beam planarization of surface.

As a result of the above processes, the LPS substrates may satisfy semiconductor substate standards: 12" (300 mm), 8" (200 mm), 6" (150 mm), 4" (100 mm), *etc.* Such LPS substrates may also be suitable for other industrial applications and may exhibit non-circular and/or other geometrical shapes.

Various properties including respective phonon scattering properties of prepared example LPS substrates are presented in below Table 1.

**Table 1**

| | **Powder** | **Example 1** | **Example 2** | **Example 3** | **Example 4** |
|---|---|---|---|---|---|
| Young's Modulus (Pa) | 8.26 × 10¹¹ | 3.73 × 10¹¹ | 4.01 × 10¹¹ | 4.42 × 1011 | 4.53 × 1011 |
| Density (kg/m³) | 3390 | 3020 | 3090 | 3170 | 3180 |
| Acoustic Velocity (m/s) | 15610 | 11113 | 11392 | 11808 | 11935 |
| Diamond (vol%) | 60% | 0% | 0.2% | 1.3% | 2.9% |
| Si (vol%) | 0% | 22% | 13.4% | 4.1% | 2.9% |
| SiC (vol%) | 40% | 78% | 86.4% | 94.6% | 94.2% |
| Theoretical Composite Thermal Conductivity (W/m-k) | 1048 | 319 | 341 | 375 | 397 |
| Measured Composite Thermal Conductivity (W/m-k) | 720 | 255 | 255 | 281 | 282 |
| Apparent Phonon Scattering Limit (%) | 31% | 20% | 25% | 25% | 29% |

In Table 1, apparent phonon scattering limit equals 1 - Cm / *Cₜ*, expressed as a percentage, where Cm is the measured composite thermal conductivity; and where *Cₜ* is the theoretical composite thermal conductivity. Moreover, the theoretical thermal conductivity is calculated, assuming no scatter and linearly per volume percentage of the various materials, using a diamond powder thermal conductivity of 1,500 W/m-k, a SiC thermal conductivity of 370 W/m-k, and a Si thermal conductivity of 140 W/m-k.

From Table 1, low diamond content (i.e., less than about 3 vol% diamond) LPS substrates, hereafter (LDC-LPS) substrates, may have phonon scattering limits that are less than about 40%, less than about 38%, less than about 36%, less than about 34%, or less than about 32%. Furthermore, LDC-LPS substrates may have a thermal conductivity of greater than about 200 W/m-k, greater than about 250 W/m-k, greater than about 260 W/m-k, greater than about 270 W/m-k, greater than about 280 W/m-k, or greater than about 290 W/m-k. Moreover, high diamond content (i.e., greater than about 55 vol%, greater than about 60 vol%, or greater than about 65 vol% diamond) LPS substrates, hereafter (HDC-LPS) substrates, may have a thermal conductivity of greater than about 600 W/m-k, greater than about 650 W/m-k, greater than about 700 W/m-k, greater than about 750 W/m-k, or greater than about 800 W/m-k.

In some embodiments, the LPS substrates, regardless of diamond content, may have a coefficient of thermal expansion (CTE) mismatch with silicon of less than about 100%, less than about 90%, less than about 80%, less than about 70%, or less than about 60%. In particular, CTE mismatch is equal to 1 - |CTE - CTE_{LPS}| / CTE expressed as a percentage, where CTE may correspond to the CTE of silicon, which is 2.6 ppm at 25°C, and where CTE_{LPS} corresponds to the CTE of the LPS substrate of interest. In the event of coupling the LPS substate to a semiconductor, optical, electronic heat-generating device, etc., the CTE of the package may be a lot higher than the silicon, possibly as high as 8 to 9 ppm.

The LPS substrates, regardless of diamond content, may also possess various geometric properties. Namely, the LPS substrates may have aspect ratios (e.g., diameter with respect to thickness) of greater than about 3, greater than about 10, greater than about 20, greater than about 50, greater than about 100, or greater than about 150. Further, the LPS substrate may have wafer diameters of greater than about 23 mm, greater than about 48 mm, greater than about 98 mm, greater than about 148 mm, greater than about 198 mm, or greater than about 298 mm. The LPS substrates may have wafer thickness of less than about 2 mm, less than about 1.5 mm, less than about, 1.0 mm, and less than about 0.85 mm.

Such LPS substrates, as well as, substrates of the above-disclosed reaction bonded diamond/SiC composites and reaction bonded diamond/SiC/Si composites may be suitable for various applications. For example, such substrates may be suitable for semiconductor device packaging. Namely, such substrates may be suitable for implementing printed circuit boards, laminate substrates, interposers, and/or signal distribution structures to which one or more semiconductor chips of a packaged semiconductor device may be mounted.

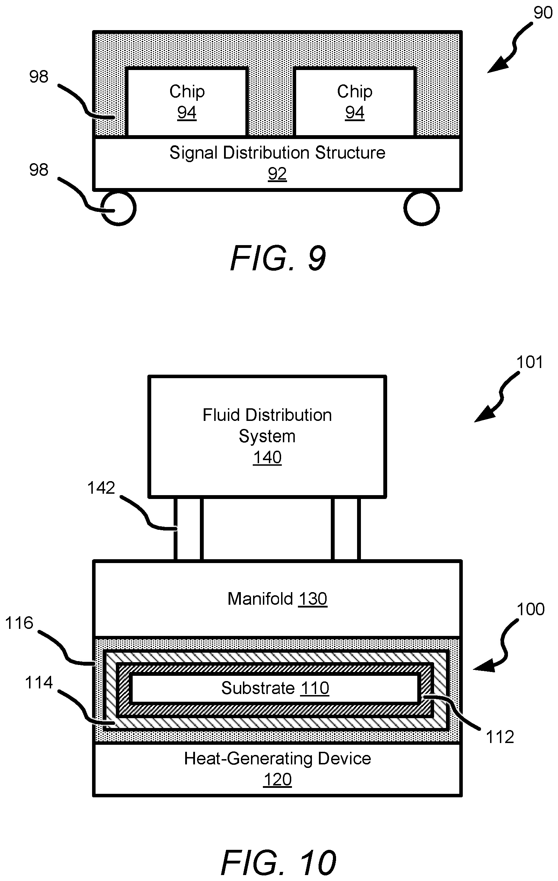

More specifically, as shown in FIG. 9, a semiconductor device 90 may include a signal distribution structure 94 and one or more semiconductor chips 94 mounted to the signal distribution structure 94. In various embodiments, the signal distribution structure 94 may be implemented as a printed circuit board, laminate substrate, interposer, or other signal distribution structure. To this end, the signal distribution structure 94 may include a LPS substrate, a reaction bonded diamond/SiC composite substrate, or reaction bonded diamond/SiC/Si composite substrate. Moreover, the signal distribution structure 94 may include one or more conductive structures (e.g., through vias, conductive traces, *etc.)* to route power, ground, data, and/or other electrical signals between the one or more semiconductor chips 94 mounted to the signal distribution structure 94.

As shown, the semiconductor device 90 may be implemented in some embodiments as semiconductor package that further includes external interconnection structures 96 *(e.g.,* solder balls, pins, lands, *etc.)* along a bottom side of the signal distribution structure 92 and an encapsulant 98 that covers the one or more semiconductor chips 94 and the top side of the signal distribution structure 94. However, in other embodiments, the semiconductor device 90 may be implemented as a mother board, main board, daughter board, etc. of a computing device or another electrical device.

Such substrates may also be suitable for cooling systems used to draw thermal energy away from heat-generating devices. In particular, as shown in FIG. 10, a cooling system 101 for a heating-generating device 120 may include a cooling plate 100 comprising a LPS substrate, reaction bonded diamond/SiC composite substrate, or a reaction bonded diamond/SiC/Si composite substrate 110, a manifold 130, and a fluid distribution system 140.

The bottom side of the cool plate 100 may be mounted to a heat-generating device 120. The heat-generating device 120 may include a graphics processing unit (GPU), a tensor processing unit (TPU), a central processing unit (CPU), optical component, electrical component, a quantum computing component, *etc,* Moreover, the manifold 130 may couple the fluid distribution system 140 to the top side of the cool plate 100 via fluid-carrying conduits 142. In various embodiments, the fluid distribution system 140 via the fluid-carrying conduits 142 may circulate fluid (e.g., gas or liquid) through the manifold 130 so as to transfer thermal energy from the heat-generating device 120 to the fluid distribution system 140 via the cool plate 100.

In some embodiments, the cool plate 100 may be mounted to the heat-generating device 120 via a thermal interface material, such as a paste, a phase change medium, and/or thermal conductive liquid *(e.g.,* a liquid metal). In such embodiments, the cool plate 100 may be further secured to the heat-generating device 120 via a clamping mechanism. In other embodiments, the cool plate 100 may be mounted to the heat-generating device 102 by an adhesive, such as an organic or inorganic glue, in which an O-ring or recess of the cool plate 100 may be filled (or not) with a filler material. In further embodiments, the cool plate 100 may be directly bonded to the heat-generating device 102 via a bonding process that involves surface activation. In yet other embodiments, the cool plate 100 may be mounted to the heat-generating device 120 by soldering or brazing the bottom side of the cool plate 100 to the heat-generating device 120. In such embodiments, the bottom side of the cool plate 100 may be metalized to provide an adhesion layer. Such adhesion layer may comprise a carbide forming element of Group IVA (such as Si and Ge), Group IVB (such as Ti, Zr, and Hf), Group VB (V, Nb, and Ta), and Group VIB (such as Cr, Mo, and W). Moreover, such adhesion layer may include a barrier layer comprising a metallic element, an insulating element, and/or a semiconducting element.

Similarly, the manifold 130 may be mounted to the cool plate 100 via various manners. In some embodiments, the manifold 130 may be mounted to the cool plate 100 via a thermal interface material, such as a paste, a phase change medium, and/or thermal conductive liquid (e.g., a liquid metal). In such embodiments, the manifold 130 may be further secured to the heat-generating device 120 via a clamping mechanism. In other embodiments, the manifold 130 may be mounted to the cool plate 100 by an adhesive, such as an organic or inorganic glue. In some embodiments, the manifold 130 may be secured to a top side of the cool plate 100 via an O-Ring. In such embodiments, the manifold 130 may be further secured to the cool plate 100 via a clamping mechanism.

In further embodiments, the manifold 130 may be directly bonded to the cool plate 100 via a bonding process that involves surface activation. In various embodiments, the manifold 130 may be mounted to the cool plate 100 via soldering or brazing. In such embodiments, one or more surfaces of the cool plate 100 may be metalized with an adhesion layer. Such adhesion layer may comprise a carbide forming element of Group IVA (such as Si and Ge), Group IVB (such as Ti, Zr, and Hf), Group VB (V, Nb, and Ta), and Group VIB (such as Cr, Mo, and W). Moreover, such adhesion layer may include a barrier layer comprising a metallic element, an insulating element, and/or a semiconducting element.

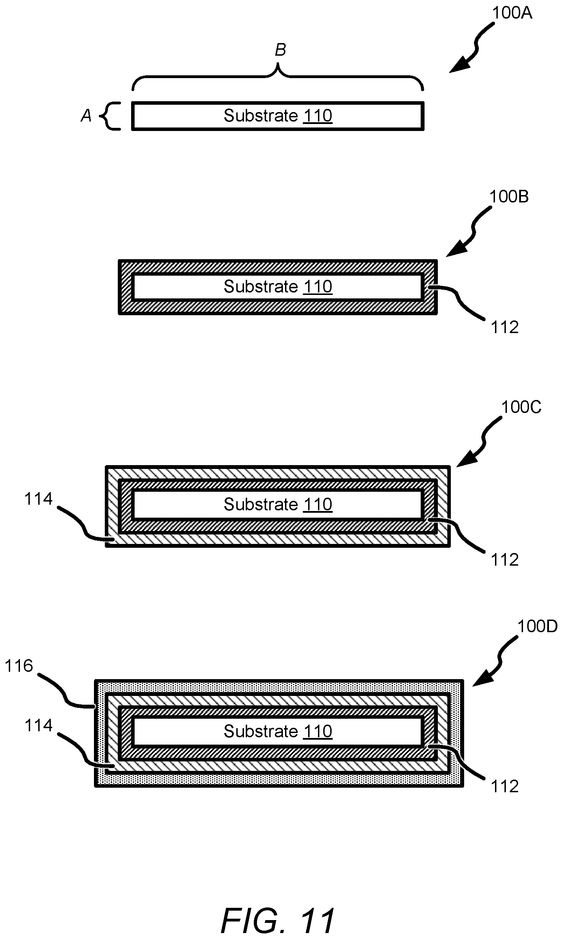

Referring now to FIG. 11, further details regarding various embodiments of the cool plate 100 are presented. In particular, FIG. 11 depicts cool plates 100A, 100B, 100C, and 100D, each of which may be used in a cooling system similar to the cooling system 101 of FIG. 10.

As shown, the cool plate 100A may be implemented as a bare LPS substrate, diamond/SiC composite substrate, or a diamond/SiC/Si composite substrate 110. As shown, the substrate 110 may have a lateral side or short geometric dimension *A* and a top side or long geometric dimension *B.* The ratio of the top side *B* to the lateral side *A (B*/*A)* may be greater than about 5, greater than about 20, greater than about 50, or greater than about 100. Moreover, the top side *B* may be greater than about 15 mm, greater than about 24 mm, greater than about 49 mm, greater than about 99 mm, or greater than ≥ 149 mm. Further, the lateral side *A* may be less than about 15 mm, less than about 10 mm, less than about 5 mm, and less than about 2 mm. Moreover, one or more of the external sides of the substrate 110 may be lapped and/or polished.

The cool plate 100B may be implemented with a substrate 110 in a manner similar to the cool plate 100A. However, the substrate 110 of the cool plate 100B may be further coated or covered in a cladding layer 112 on one or more external surfaces of the substrate 110. The cladding layer 112 may comprise one or more insulating materials such as, for example, oxides, nitrides, carbides, borides, arsenides, silicides, phosphides, *etc.* The cladding layer 112 may, alternatively or additionally, include one or more layers of semiconductor materials such as silicon, germanium, etc. Moreover, such semiconductor materials may be doped. The cladding layer 112 may, alternatively or additionally, include one or more metallic and/or transition metal materials such as, for example, Group 3A, Group 4A, Group 5A metallic materials, and/or Group 3B to Group 10B transition metal materials.

In some embodiments, the cladding layer 112 may clad all cladded surfaces of the substrate 110 with the same material. In other embodiments, one or more external surfaces of the substrate 110 may be cladded with a material that is different than those used to clad one or more other external surfaces of the substrate 110. Finally, in some embodiments, one or more of the external surfaces of the cladding layer 112 may be lapped and/or polished.

The cool plate 100C may be implemented with a substrate 110 and cladding layer 112 in a manner similar to the cool plate 100B. However, the cool plate 100C may further include a cover layer 114 that coats or covers one or more external surfaces of the cladding layer 112 and/or substrate 110. In general, the cover layer 114 may be implemented in a similar manner to the cladding layer 112. However, the cover layer 114 in various embodiments may be implemented with high purity materials *(e.g.,* materials with contamination levels of less than about 5 × 10¹¹ / cm²_{,} less than about 1 × 10¹⁰ / cm², or less than about 2 × 10¹⁰ / cm²). More specifically, the cover layer 114 may comprise one or more high purity insulating materials such as, for example, oxides, nitrides, carbides, borides, arsenides, silicides, phosphides, *etc.* The cover layer 114 may, alternatively or additionally, include one or more layers of high purity semiconductor materials such as silicon, germanium, etc. Moreover, such high purity semiconductor materials may be doped. The cover layer 114 may, alternatively or additionally, include one or more high purity metallic and/or high purity transition metal materials such as, for example, Group 3A, Group 4A, Group 5A metallic materials, and/or Group 3B to Group 10B transition metal materials.

In some embodiments, the cover layer 114 may provide the same cover materials on all covered surfaces of the cladding layer 112 and/or substrate 110. In other embodiments, one or more external surfaces of the cladding layer 112 and/or substrate 110 may be covered with a material that is different than those used to cover one or more other external surfaces of the cladding layer 112 and/or substrate 110. Finally, in some embodiments, one or more of the external surfaces of the cover layer 114 may be lapped and/or polished.

The cool plate 100D may be implemented with a substrate 110, cladding layer 112, and cover layer 114 in a manner similar to the cool plate 100C. However, the cool plate 100D may further include a metal layer 116 that further coats or covers one or more external surfaces of the cover layer 114, cladding layer 112, and/or substrate 110. In general, the metallic layer 116 may be implemented in a similar manner to the cover layer 114. In some embodiments, the metal layer 116 may provide carbide forming metal such as Group 3A and 4A metals, and/or transitional metals such as Si, Ge, Cr, Ta, W, Mo, *etc.* Such carbide forming metals may effectively provide the cool plate 100D with an adhesion layer suitable for adhering to a heat-generating device through reaction bonding or other processes. In other embodiments, the metallic layer 116 may comprise one or more metals from Groups IIIA, Group IVA, Group VA, and Group IB to Group VIIB, for example, Ni, Au, Pt, Cu, *etc.* In such embodiments, the metallic layer 116 may provide the cool plate 100D with a metallic barrier.

In some embodiments, the metallic layer 116 may provide the same metallic materials on all covered surfaces of the cover layer 114, cladding layer 112, and/or substrate 110. In other embodiments, one or more external surfaces of the cover layer 114, cladding layer 112, and/or substrate 110 may be covered with a material that is different than those used to cover one or more other external surfaces of the cover layer 114, cladding layer 112, and/or substrate 110. Finally, in some embodiments, one or more of the external surfaces of the metallic layer 116 may be lapped and/or polished.

The present disclosure produces Si-free diamond-SiC composites using the reaction bonding process where the composites are "Si-free" (e.g. little to no residual Si phase) and have high thermal conductivity. Conventional reaction bonded ceramic materials (such as the one described above) have poor properties in some applications, such as those exposed to high temperature, those exposed to corrosion and/or those requiring ultra-high thermal conductivity, at least in part because of the presence of residual Si. Thus, in one embodiment of the present disclosure, a preform is produced containing particularly sized diamond particles, which is reactively infiltrated with molten Si. The diamond and Si react to form SiC (Si + C → SiC), which consumes the residual Si from the infiltration process, resulting in a composite having very low (near zero) residual Si.

In the creation of reaction bonded diamond-SiC composites as described herein, one or more of the following are utilized: - RVD (crushed) vs. MBD (rounded) diamond powders; smaller diamond particle sizes *(i.e.,* more surface area for reaction); particle size blends (higher diamond packing, leaving less volume for Si/SiC matrix phase); and/or optimized process times (to maximize Si + diamond SiC reaction).

A Si-free version of diamond-SiC composites *(e.g.* RB-diamond) would have value in many markets where there is a need for attractive cost, significant size and shape capability and the attributes provided by a diamond/SiC microstructure. The diamond-SiC composites as described herein may be used to make a variety of components. Example components include, but are not limited to, thermal management applications (datacenter micro-coolers, power electronic heat sinks, semiconductor prober chucks, *etc.);* armor tiles; industrial wear and refractory components; corrosion applications (semi focus and RTP rings, chemical processing components, mining, *etc.;* and high temperature aerospace components.

Disclosed herein is a method utilizing diamond particles to produce RB-diamond ceramic with low, ultra-low or nominally zero residual Si and having high or ultra-high thermal conductivity. In some embodiments, at least some of the diamond particles are high surface area (*i.e*., fine size) for enhanced reactivity. In some embodiments, the diamond particles are a blend of sizes to enhance particle packing. In other embodiments, the diamond particles are crushed (RVD) rather than rounded (MBD).

In an embodiment, methods are used to achieve high packing density in the preform. In other embodiments, infiltration parameters are used to achieve low residual Si content and minimal thermal degradation of the diamond particles.

In one embodiment, reaction bonded diamond/SiC components having low, ultra-low or nominally zero residual Si after processing are produced, where the components include, but are not limited to, thermal management components (micro cooler, heat sink); armor tile components and components; and/or semiconductor applications (focus rings, RTP rings, other).

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

Further aspects of the invention are described in the following clauses:
Clause 1. A low phonon scattering substrate, comprising:
   a composite material comprising silicon carbide reaction bonds between thermal conductive particles; and
   wherein the composite material has a phonon scattering limit of less than about 40%.
Clause 2. The low phonon scattering substrate of clause 1, wherein the composite material has a phonon scattering limit of less than about 38%.
Clause 3. The low phonon scattering substrate of clause 1, wherein the composite material has a phonon scattering limit of less than about 36%.
Clause 4. The low phonon scattering substrate of clause 1, wherein the composite material has a phonon scattering limit of less than about 34%.
Clause 5. The low phonon scattering substrate of clause 1, wherein the composite material has a phonon scattering limit of less than about 32%.
Clause 6. The low phonon scattering substrate of clause 1, wherein the composite material comprises greater than about 55 vol% diamond.
Clause 7. The low phonon scattering substrate of clause 1, wherein the composite material comprises greater than about 60 vol% diamond.
Clause 8. The low phonon scattering substrate of clause 1, wherein the composite material comprises greater than about 65 vol% diamond.
Clause 9. The low phonon scattering substrate of clause 6, wherein the composite material comprises a blend of diamond particle sizes.
Clause 10. The low phone scattering substrate of clause 9, wherein the blend of diamond particle sizes comprises two different sizes have a ratio of larger to smaller particles in a range of about 80-60 : 20-40.
Clause 11. The low phonon scattering substrate of clause 6, wherein the composite material has a thermal conductivity greater than about 600 W/m-k.
Clause 12. The low phonon scattering substrate of clause 6, wherein the composite material has a thermal conductivity greater than about 650 W/m-k.
Clause 13. The low phonon scattering substrate of clause 6, wherein the composite material has a thermal conductivity greater than about 700 W/m-k.
Clause 14. The low phonon scattering substrate of clause 6, wherein the composite material has a thermal conductivity greater than about 750 W/m-k.
Clause 15. The low phonon scattering substrate of clause 6, wherein the composite material has a thermal conductivity greater than about 800 W/m-k.
Clause 16. The low phonon scattering substrate of clause 1, wherein the composite material comprises less than about 3 vol% diamond.
Clause 17. The low phonon scattering substrate of clause 16, wherein the composite material has a thermal conductivity of greater than about 250 W/m-k.
Clause 18. The low phonon scattering substrate of clause 16, wherein the composite material has a thermal conductivity of greater than about 270 W/m-k.
Clause 19. The low phonon scattering substrate of clause 16, wherein the composite material has a thermal conductivity of greater than about 290 W/m-k.
Clause 20. The low phonon scattering substrate of clause 1, wherein the thermal conductive particles include boron nitride particles.
Clause 21. The low phonon scattering substrate of clause 1, comprising:
   a diameter and a thickness; and
   wherein a ratio of the diameter with respect to the thickness is greater than about 3, greater than about 10, greater than about 20, greater than about 50, greater than about 100, or greater than about 150.
Clause 22. The low phonon scattering substrate of clause 1, comprising a diameter of greater than about 23 mm, greater than about 48 mm, greater than about 98 mm, greater than about 148 mm, greater than about 198 mm, or greater than about 298 mm.
Clause 23. The low phonon scattering substrate of clause 1, comprising a thickness of less than about 2 mm, less than about 1.5 mm, less than about, 1.0 mm, and less than about 0.85 mm.
Clause 24. A cool plate, comprising:
   the low phonon scattering substrate of clause 1; and
   a cladding layer covering one or more external surfaces of the low phonon scattering substrate.
Clause 25. The cool plate of clause 24, comprising a high purity cover layer covering one or more external surfaces of the cladding layer and/or the low phonon scattering substrate.
Clause 26. The cool plate of clause 25, comprising a metallic layer covering one or more external surfaces of the cover layer, the cladding layer, and/or the low phonon scattering substrate.
Clause 27. A cooling system for a heat-generating device, the cooling system comprising:
   the cooling plate of clause 24 coupled to the heat-generating device; and
   a fluid distribution system coupled to the cooling plate.
Clause 28. A packaged device, comprising
   signal distribution structure comprising the low phonon scattering substrate of clause 1; and
   one or more semiconductor chips, optical devices, and/or electronic devices mounted to the signal distribution structure.

## Claims

1. A low phonon scattering substrate, comprising:
a composite material comprising silicon carbide reaction bonds between thermal conductive particles; and
wherein the composite material has a phonon scattering limit of less than about 40%.

2. The low phonon scattering substrate of claim 1, wherein the composite material has a phonon scattering limit of less than about 38%, or less than about 36%, or less than about 34%, or less than about 32%.

3. The low phonon scattering substrate of claim 1 or 2, wherein the composite material comprises greater than about 55 vol% diamond, or greater than about 60 vol% diamond, or greater than about 65 vol% diamond.

4. The low phonon scattering substrate of claim 3, wherein the composite material comprises a blend of diamond particle sizes.

5. The low phonon scattering substrate of claim 4, wherein the blend of diamond particle sizes comprises two different sizes having a ratio of larger to smaller particles in a range of about 80-60 : 20-40.

6. The low phonon scattering substrate of any one of claims 1-5, wherein the composite material has a thermal conductivity greater than about 600 W/(m*K), or greater than about 650 W/(m*K), or greater than about 700 W/(m*K), or greater than about 750 W/(m*K), or greater than about 800 W/(m*K).

7. The low phonon scattering substrate of claim 1 or 2, wherein the composite material comprises less than about 3 vol% diamond.

8. The low phonon scattering substrate of claim 7, wherein the composite material has a thermal conductivity of greater than about 250 W/(m*K), or greater than about 270 W/(m*K), or greater than about 290 W/(m*K).

9. The low phonon scattering substrate of any one of claims 1-8, wherein the thermal conductive particles include boron nitride particles.

10. The low phonon scattering substrate of any one of claims 1-9, comprising:
a diameter and a thickness; and
wherein a ratio of the diameter with respect to the thickness is greater than about 3, greater than about 10, greater than about 20, greater than about 50, greater than about 100, or greater than about 150.

11. The low phonon scattering substrate of any one of claims 1-10, comprising a diameter of greater than about 23 mm, greater than about 48 mm, greater than about 98 mm, greater than about 148 mm, greater than about 198 mm, or greater than about 298 mm, and/or comprising a thickness of less than about 2 mm, less than about 1.5 mm, less than about, 1.0 mm, and less than about 0.85 mm.

12. A cool plate, comprising:
the low phonon scattering substrate of any one of claims 1-11; and
a cladding layer covering one or more external surfaces of the low phonon scattering substrate.

13. The cool plate of claim 12, comprising a high purity cover layer covering one or more external surfaces of the cladding layer and/or the low phonon scattering substrate, preferably comprising a metallic layer covering one or more external surfaces of the cover layer, the cladding layer, and/or the low phonon scattering substrate.

14. A cooling system for a heat-generating device, the cooling system comprising:
the cool plate of claim 12 or 13 coupled to the heat-generating device; and
a fluid distribution system coupled to the cool plate.

15. A packaged device, comprising
a signal distribution structure comprising the low phonon scattering substrate of any one of claims 1-11; and
one or more semiconductor chips, optical devices, and/or electronic devices mounted to the signal distribution structure.
